# EUROPEAN PATENT APPLICATION

(11) **EP 3 779 483 A1**
(43) Date of publication of application: **17.02.2021**
(21) Application number: 18914084.1
(22) Date of filing: 12.06.2018
(51) Int. Cl.: G01R 31/36, H02J 7/00

(54) **ENERGY STORAGE DEVICE CHARGING STATE FIBER ONLINE MONITORING SYSTEM AND METHOD**

(30) Priority: 12.04.2018 CN 201810325936
(71) Applicant: Jinan University, Tianhe District Guangzhou Guangdong 510632 (CN)
(72) Inventor: GUO, Tuan, Guangdong 510632 (CN); MAI, Wenjie, Guangdong 510632 (CN); LAO, Jiajie, Guangdong 510632 (CN); SUN, Peng, Guangdong 510632 (CN)
(74) Representative: Mozzi, Matteo
(86) International application number: PCT/CN2018/090809
(87) International publication number: WO 2019/196193

(57) **Abstract**

A system and method for monitoring the state of charge (SOC) of an energy storage device are provided. The system includes a light source, a polarizer, a polarization controller, an optical fiber circulator, an optical fiber sensing probe, and a spectrometer. The light source, the polarizer, the polarization controller, the optical fiber circulator and the optical fiber sensing probe are sequentially connected. The spectrometer is connected with the optical fiber circulator. The optical fiber sensing probe is in a supercapacitor. The supercapacitor is operably connected with an electrochemical workstation. The optical fiber sensing probe can transmit optical signals and acquire optical wave information for *in operando* monitoring electric potentials during charging/discharging of the supercapacitor and for storing electric charge quantity information, can be implemented into a small space for *in situ* measurement, and can simultaneously measure changes of parameters, such as SOC, electric potentials, and temperatures.

## Description

### TECHNICAL FIELD

The present disclosure relates to a system and method capable of *in situ* and *in operando* monitoring a state of charge (SOC) of an energy storage device, and in particular to an optical fiber-based system and method for monitoring the SOC of an energy storage device. The present disclosure belongs to the field of optical fiber-based electrochemical sensor design.

### BACKGROUND

At present, the energy field on earth is facing various huge challenges. With the consumption of fossil fuels such as petroleum, coal and natural gas and the excessive emission of greenhouse gases, the structure of energy supply for the human society shall develop from non-renewable energy sources to renewable energy sources, in order to solve the issues of the exhaustion of energy sources and the rises of sea levels. Whether these issues can be solved depends mainly on the effective use and management of energy equipment and systems. In the past two or three decades, rapid progresses have been made in the fields of information technologies and electronics technologies. In currently widely used commercial mobile phones, traditional lithium-ion batteries are selected as the power supply. The complex encapsulation of the traditional lithium-ion batteries has limited the miniaturization of the mobile phones in terms of their volumes and weights. This above problem can also be encountered in other application fields involving the use of traditional lithium-ion batteries. Therefore, the development of new-type and flexible energy supply devices is an urgent research and development topic in the field of energy equipment.

Driven by a series of demands, the supercapacitor technologies are emerging. A supercapacitor, also known as an electrochemical capacitor, is a new type of energy storage device that has been rapidly developed in recent years. Its working principle is to store electric energy using an electrical double layer formed on the surfaces of electrodes or to store electric energy utilizing the two-dimensional or quasi-two-dimensional Faraday reactions. This research field involves energy, materials, chemistry, electric devices, etc., and has become one of the interdisciplinary research hotspots.

Because of advantages such as fast charging and discharging speeds, long service lives, good temperature characteristics, and being environment-friendly, supercapacitors have received wide attentions. At present, the detection methods for supercapacitors are substantially all "off-line". In other words, the state of charge (SOC) of a supercapacitor cannot traditionally be measured *in operando,* i.e. while the supercapacitor is in a charging/discharging working mode, but it needs to wait until the supercapacitor stops working, when an electrochemical workstation is commonly used to examine whether the electrochemical performance of the electrodes in the supercapacitor is attenuated or damaged. A supercapacitor can be currently tested while it is in a working mode by means of a transmission electron microscope (TEM) or a cryoelectron microscope, but because the equipment such as TEM and the cryoelectron microscope are very expensive and are not suitable for *in situ* measurement, such an *in situ* and *in operando* supercapacitor monitoring technology has not yet been advanced much and has not yet witnessed wide applications.

### SUMMARY

One objective of the present disclosure is to provide an optical fiber system for *in operando* monitoring a state of charge (SOC) of an energy storage device (e.g. capacitor, supercapacitor, etc.) in order to address the above-mentioned issues associated with existing technologies. The system utilizes an optical fiber sensing probe as fine as a hair, which can both transmit optical signals and acquire optical wave information to thereby realize an *in operando* and *in situ* monitoring of the electric potentials in the energy storage device during the charging process and/or the discharging process thereof and to realize a real-time or *in operando* obtaining of the quantity information of electric charges.

Another objective of the present disclosure is to provide an optical fiber-based method for monitoring a state of charge (SOC) of an energy storage device *in operando.* The method can be implemented even in a relatively narrow and small space to realize an *in situ* measurement. The method can also be implemented in a real-time or *in operando* manner to simultaneously measure multiple parameters of the energy storage device, such as an SOC, an electric potential, a temperature, etc. In addition, the method inherits the low-loss transmission characteristics of optical fibers. Because the sensing probe and light transmission path are by means of a same optical fiber, thus a long-distance, *in operando,* and real-time monitoring can be realized.

To achieve the one objective, the present disclosure adopts the following technical solutions:
An optical fiber system capable of measuring SOC of an energy storage device *in operando* and *in situ* is provided, which includes a light source, a polarizer, a polarization controller, an optical fiber circulator, an optical fiber sensing probe, and an optical fiber spectrometer. The light source, the polarizer, the polarization controller, the optical fiber circulator and the optical fiber sensing probe are operably connected in a sequential manner. The optical fiber spectrometer is operably connected with the optical fiber circulator. The optical fiber sensing probe is arranged in an energy storage device (e.g. a supercapacitor, esp. electrochemical supercapacitor), and is aligned/attached tightly, thereby to be operably coupled, with one electrode of the energy storage device. The energy storage device can be optionally connected with an electrochemical workstation.

The optical fiber sensing probe includes an optical fiber. The optical fiber is engraved with a tilted grating in the core, and an outer surface of the cladding of the optical fiber is coated with a metal film having a uniform thickness at a nanometer scale. Lights emitted by the light source sequentially pass through the polarizer, the polarization controller and the optical fiber circulator, and then shed into the optical fiber sensing probe. A cladding mode generated in the optical fiber of the optical fiber sensing probe is coupled to the metal film coating the outer surface of the cladding of the optical fiber to thereby stimulate or excite a surface plasmon resonance (SPR) of the metal film. The plasma resonance waves exhibit as an absorption envelope in the reflection spectrum of the optical fiber spectrometer. When the dielectric constant of the metal film changes under the action of charging and/or discharging of the supercapacitor, the amplitude/intensity of the absorption envelope alters accordingly.

Herein, the tilted grating in the optical fiber can be made, for example, by means of an excimer laser and a phase mask, or by means of double beam interference. The tilted grating can optionally have an inclination angle of approximately 5-25 degrees and a total axial length of approximately 10-20 mm.

Optionally in the optical fiber sensing probe, an end surface of the optical fiber can be coated with a metal reflective film with a thickness of more than 200 nm.

For the optical fiber sensing probe, the outer surface of the cladding of the optical fiber can optionally be first coated with a transition layer of a chromium film having a thickness of approximately 2-3 nm by means of magnetron sputtering or thermal evaporation deposition, and can then be coated with a metal film having a uniform thickness at a nanometer scale. Then the optical fiber coated with the metal film can optionally further undergo an annealing treatment.

The supercapacitor is filled with an electrolyte therein, and is provided with two electrodes. Part of each electrode is disposed in the electrolyte. The optical fiber sensing probe can be tightly aligned, attached, packaged, or bundled, and thereby electrochemical coupled, with one of the two electrodes.

In embodiments where the optical fiber system includes an electrochemical workstation, the electrochemical workstation can be provided with a counting electrode, a reference electrode and a working electrode. The counting electrode and the reference electrode are both electrically connected to one of the two electrodes of the supercapacitor, and the working electrode is electrically connected to another of the two electrodes of the supercapacitor.

To achieve the second objective as described above, the present disclosure further provides the following technical solutions:
An optical fiber-based method for *in operando* monitoring a state of charge (SOC) of an energy storage device is provided. The method substantially utilizes the optical fiber system as described above. Using a supercapacitor as an illustrating example for the energy storage device, the method includes the following steps:
S1: Tightly aligning or attaching the optical fiber sensing probe with one of the two electrodes of the supercapacitor, and filing an electrolyte in the supercapacitor.
S2: Operably connecting the supercapacitor with the electrochemical workstation, and operably connecting the electrochemical workstation and the optical fiber spectrometer to a computer. Through this step, an optical path can be set up, which is configured such that a light emitted from the light source can pass through the polarizer to be thereby converted into a polarized light, and the polarization controller can further adjust the polarization direction of the polarized light before such adjusted polarized light further passes through the optical fiber circulator and enters into the optical fiber sensing probe. Relevant parameters can be configured to adjust the polarization controller to thereby allow the light incident into the optical fiber sensing probe to be in a polarized state capable of exciting surface plasma resonance (SPR) on the metal film.
S3: Monitoring, after arranging the supercapacitor under a natural condition, a state of change (SOC) of the supercapacitor during the charging process and the discharging process thereof for respectively storing an electric energy into, and releasing an electric energy from, the supercapacitor by means of an optical and electrochemical approach.
S4: Applying different electric potentials to the supercapacitor to control polarity and quantity of electric charges stored therein to thereby control a change of electric charge density on a surface of the optical fiber sensing probe, such that changes of the SOC during storage and/or release of electric charges in the supercapacitor can be monitored.

In the above step S2, the polarized light can be configured to have a polarization direction substantially parallel to a writing direction of the tilted grating in the optical fiber. Herein, the polarization direction of the polarized light can be determined by the amplitude/intensity of the surface plasmon resonance peaks. Specifically, when the polarization direction of the polarized light is parallel to the writing direction of the tilted grating, the surface plasmon resonance peaks have a maximum amplitude/intensity.

In step S3 of monitoring, after arranging the supercapacitor under a natural condition, a state of change (SOC) of the supercapacitor during the charging process and the discharging process thereof for respectively storing an electric energy into, and releasing an electric energy from, the supercapacitor by means of an optical and electrochemical approach, the following process may be involved.

The supercapacitor is charged or discharged under the excitation of electrochemical workstation. When the supercapacitor is being charged, ions in the electrolyte can form an electrical double layer on the surface of the supercapacitor electrodes to thereby store the electric energy. Accompanying an oxidation reaction on an electrode material, the electric charge is further accumulated on the supercapacitor electrodes, and the electric energy stored in the supercapacitor reaches a maximum after the charging process is completed. When the supercapacitor is being discharged, a reduction reaction occurs on the supercapacitor electrode material, and the ions that have accumulated on the surface of the supercapacitor electrodes to form the electrical double layer can diffuse back into the electrolyte in a process that is opposite to the charging process.

During the whole charging and discharging process, the optical fiber sensing probe can monitor the real-time change of the state of charge (SOC) of the supercapacitor. The electrochemical workstation and the optical fiber spectrometer further record the process in which the state of charge (SOC) of the supercapacitor increases during charging and/or reduces during discharging, and then a corresponding curve can be drawn.

Furthermore, the monitoring results recorded by the optical fiber spectrometer can be further corrected by the wavelength drifts and the amplitude/intensity changes of a core mode of the optical fiber.

Furthermore, in the above step S4, the following may be specifically involved:
When a positive potential is applied, the density of negative ions at the end of the supercapacitor electrode that is tightly aligned/attached with the optical fiber sensing probe increases, and the metal film is in a state of electron polarization. When a negative potential is applied, the density of positive ions at the end of the supercapacitor electrode that is tightly aligned/attached with the optical fiber sensing probe increases, and the metal film is in an opposite state of electron polarization.

The change of electric charge density on the surface of the optical fiber sensing probe can be detected through an amplitude/intensity change of the cladding mode of the tilted grating corresponding to the wavelength of the absorption envelope of the plasma resonance wave modulated by the wavelength shift of the absorption envelope of the plasma resonance wave, thereby converting the information of electric charges that are stored in and/or released by the supercapacitor into electrochemical-optical information in order for measurement.

Compared with existing technologies, the inventions disclosed herein have the following beneficial effects:
1. The inventions disclosed in the present disclosure utilizes an optical fiber sensing probe as fine as hair which can both transmit optical signals and acquire optical wave information to thereby realize an *in situ* monitoring of the electric potentials in a supercapacitor during the charging process and/or the discharging process thereof and to realize an *in operando* recording of the quantity information of electric charges. It can be implemented into a relatively narrow and small space to thereby realize an *in situ* measurement, and can also be implemented in a simultaneous and real-time (or in operando) manner to measure changes of multiple parameters, such as a state of charge (SOC), an electric potential, a temperature, etc.
2. The outer surface of the optical fiber sensing probe is coated with a metal film. The optical fiber sensing probe couples the energy of the surface plasmon resonance wave generated on the metal film to the external environment outside the metal film. The energy loss and the wavelength shift of the resonance center generated due to the interaction between the plasma resonance wave and the electrode material close to the surface of the metal film exhibits as an absorption envelope detected by the optical fiber spectrometer. The combination of the above multidisciplinary technologies (e.g. electrochemical technology, and the surface plasmon resonance technology) can realize the real-time and *in situ* monitoring of the charging and/or discharging process of a supercapacitor, which provides a new application prospect for monitoring the working conditions of various energy storage device.
3. The high-sensitivity surface plasmon resonance technology can replace the traditional triangular prism having tens of millimeter-scale with a compact optical fiber sensing probe having only a hundred-micron scale, thus realizing the miniaturization of the sensing probe. Such a sensing probe can be inserted into a space that is difficult to reach or accessible to by traditional sensors in order for an *in situ* detection.
4. In the present disclosure, the sensing probe and the signal-transmitting optical fiber shares a same optical fiber. Because of the low-loss characteristic of optical fibers, signals transmitted thereby almost do no attenuate even after a long-distance transmission, which can greatly improve the detection accuracy of a sensor. Thus, the system and method disclosed herein can be used to realize a long-distance, *in operando,* and real-time monitoring, thereby overcoming the defects associated with the existing technologies that require an offline testing.
5. In the present disclosure, the metal film on the outer surface of the optical fiber cladding in the optical fiber sensing probe has a nanometer-level uniform thickness, which can ensure that the plasma resonance is stimulated with the best efficiency. The metal film is not only the carrier of the optical signal of the plasma resonance, but also has a good conductivity, thus it can also be used as a carrier for micro-current transmission.
6. In the present disclosure, the end surface of the optical fiber in the optical fiber sensing probe is coated with a metal reflective film with a thickness of more than approximately 200 nm, and as such, the optical signals can be reflected by the metal reflective film to realize the probe-type measurement.
7. In the present disclosure, the outer surface of the optical fiber cladding in the optical fiber sensing probe, before being coated with a metal film of nanometer thickness, can be coated with a transition layer of a chromium film with a thickness of approximately 2-3 nm by magnetron sputtering, so as to increase the adhesion between the metal film and the surface of the optical fiber cladding. After coating of the metal film, the optical fiber coated with the metal film can further undergo an annealing treatment, so as to increase the adhesion for the metal film and to release the residual stress in the coating process.
8. In the present disclosure, the core mode of the optical fiber in the optical fiber sensing probe is sensitive only to temperature, but not to the environmental refractive index. Therefore, by detecting the optical fiber core mode, the real-time measurement of temperature information can also be realized, thereby eliminating the influence of temperature changes on the measurement results. At the same time, the amplitude change of the optical fiber core mode can be used to calibrate the interferences in the optical path, thereby conferring a functionality of self-calibration.

### BRIEF DESCRIPTION OF THE DRAWINGS

FIG. 1 is a schematic diagram of an optical fiber system for *in operando* monitoring the state of charge (SOC) of an energy storage device according to certain embodiments of the present disclosure.
FIG. 2 illustrates the working principle of the optical fiber sensing probe in the optical fiber system for *in operando* monitoring the state of charge (SOC) of an energy storage device according to certain embodiments of the present disclosure.
FIG. 3(a) shows a cyclic voltammetry (CV) response profile of a supercapacitor tested at a scanning rate of 10 mV/s.
FIG. 3(b) shows a relationship between the plasma resonance intensity/amplitude of an optical fiber sensing probe and the electric potential of a supercapacitor.
FIG. 4 shows the optical responding curves of the core-mode resonance and the SPR resonance detected by the optical fiber sensing probe that corresponds to a charging and discharging cycle in a CV response curve of a supercapacitor.
FIG. 5(a) shows the cyclic voltammetry response profiles of a supercapacitor at a series of different scanning rates.
FIG. 5(b) shows the electrochemical responding curves of the electric charges stored in the supercapacitor when the supercapacitor is under the cyclic voltammetry (CV) test at the series of different scanning rates in FIG. 5 (a).
FIG. 5(c) shows the intensity/amplitude change curves of SPR resonance detected by the optical fiber sensing probe when the supercapacitor is under a cyclic voltammetry charge-discharge test at the series of scanning rates (shown in FIG. 5(a)).
FIG. 5(d) shows the Galvanostatic charge-discharge (GCD) curves of the supercapacitor disclosed herein under a GCD test at different currents.
FIG. 5(e) shows the quantity change curves of the electric charges stored in the supercapacitor when the supercapacitor is under the GCD test at the different currents (shown in FIG. 5(d)).
FIG. 5(f) shows the intensity/amplitude change curves of the SPR resonance detected by the optical fiber sensing probe when the supercapacitor is under the GCD test at the different currents (shown in FIG. 5(d)).
FIG. 5(g) shows the Galvanostatic charge and voltage holding (GCVH) curves of the supercapacitor disclosed herein under a GCVH test at different high electric potentials.
FIG. 5(h) shows the quantity change curves of the electric charges stored or released by the supercapacitor when the supercapacitor is under the GCVH test at the different high potentials (shown in FIG. 5(g)).
FIG. 5(i) shows the intensity/amplitude change curves of the SPR resonance detected by the optical fiber sensing probe when the supercapacitor is under the GCVH test at the different high potentials (shown in FIG. 5(g)).

In the above drawings, the corresponding relationships between the reference numbers and the objects that these reference numbers corresponding to are as follows: 1-light source; 2-polarizer; 3-polarization controller; 4-optical fiber circulator; 5-optical fiber sensing probe; 6-supercapacitor; 7-optical fiber spectrometer; 8-electrochemical workstation; 9-supercapacitor electrode; 10-working electrode; 11-counting electrode; 12-reference electrode; 13-tilted grating; 14-metal film; 15-plasmon resonance wave; 16-supercapacitor electrode material; 17-ions; 18-metal reflective film.

### DETAILED DESCRIPTION

In the following, the inventions disclosed herein will be described in further detail in combination with embodiments and drawings that are attached herewith. It is noted that these embodiments impose no limitations.

### Embodiment 1:

In an optical fiber sensor having titled gratings, such as tilted fiber Bragg grating (TFBG), the TFBGs can excite hundreds of modes with different sensitivities to the surrounding environment. By coating a metal film having a composition of gold, silver, etc. on the surface of the optical fiber, the cladding modes of the tilted FBG that meet the phase matching conditions can be coupled to the metal film to thereby form plasma resonance waves. The plasma resonance waves are very sensitive to changes of the dielectric constant, the electrode potential, and the density of electric charges of the metal film. Compared with traditional optical fiber sensing approaches with the evanescent field effect, the plasma resonance waves have higher detection sensitivity.

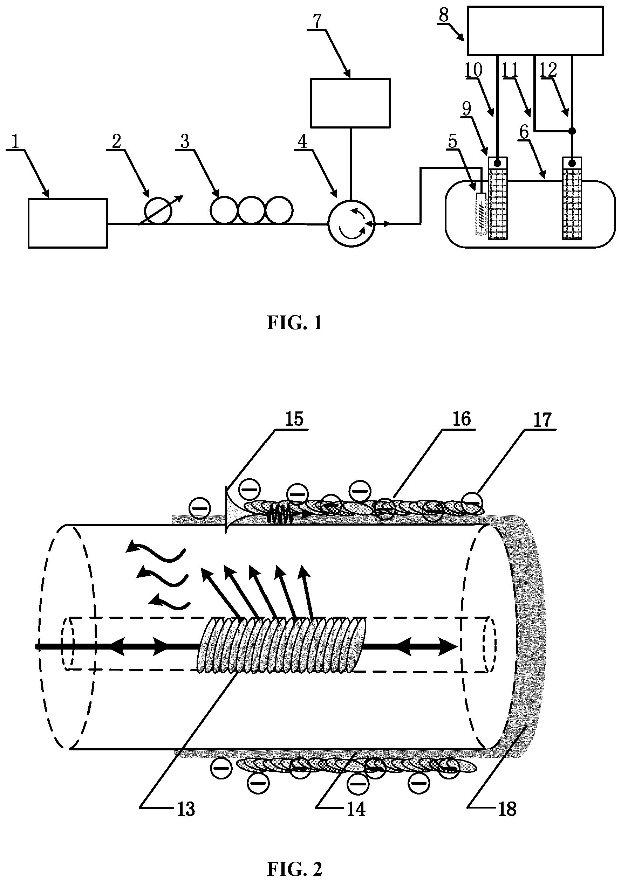

As illustrated in FIG. 1, this embodiment of the disclosure provides an optical fiber system capable of *in operando* monitoring a state of charge (SOC) of an energy storage device, such as a supercapacitor herein, which includes a light source 1, a polarizer 2, a polarization controller 3, an optical fiber circulator 4, an optical fiber sensing probe 5, and an optical fiber spectrometer 7. The light source 1, the polarizer 2, the polarization controller 3, the optical fiber circulator 4 and the optical fiber sensing probe 5 are operably connected in a sequential manner. The optical fiber spectrometer 7 is operably connected with the optical fiber circulator 4. The optical fiber sensing probe 5 is arranged in a supercapacitor 6 to be monitored, and the supercapacitor 6 is operably connected with an electrochemical workstation 8.

In this embodiment, the supercapacitor 6 is filled with an electrolyte, and is provided with two supercapacitor electrodes 9. Part of each supercapacitor electrode 9 is disposed in the electrolyte. The optical fiber sensing probe 5 is tightly aligned or packaged tightly with one of the two supercapacitor electrodes 9. The electrochemical workstation 8 includes a working electrode 10, a counting electrode 11, and a reference electrode 12. The counting electrode 11 and the reference electrode 12 are electrically connected to one of the two supercapacitor electrodes 9 of the supercapacitor 6, and the working electrode 10 is electrically connected to another of the two supercapacitor electrodes 9 of the supercapacitor 6 through wiring.

As further shown in FIGS. 1 and 2, the optical fiber sensing probe 5 includes an optical fiber, which is engraved with a tilted grating 13 in the core. An outer surface of a cladding of the optical fiber is coated with a metal film 14 having a uniform thickness at a nanometer scale. The metal film 14 is not only the carrier for optical signals of the plasma resonance, but is also the transmission carrier for microcurrents. A light emitted by the light source 1 sequentially passes through the polarizer 2, the polarization controller 3 and the optical fiber circulator 4, and then enters into the optical fiber sensing probe 5. A cladding mode generated in the optical fiber of the optical fiber sensing probe 5 can be coupled to the metal film 14 that coats the outer surface of the cladding of the optical fiber to thereby stimulate a surface plasmon resonance (SPR) of the metal film 14. The optical fiber sensing probe 5 evanesces a light containing a plasma resonance wave 15 to an external environment outside the metal film 14, and the light interacts with the supercapacitor electrode material 16 on the surface of the supercapacitor electrode 9. At the same time, ions 17 in the electrolyte enter into the two-dimensional or three-dimensional space of the supercapacitor electrode material 16 to allow the redox reactions to occur and the density of electric charges near the supercapacitor electrode 9 to change, causing an energy loss of, and a wavelength shift of the resonance center of, the plasma resonance wave 13. This phenomenon can be captured and shown in the optical fiber spectrometer 7 such that the plasma resonance wave 15 exhibits as an absorption envelope in the reflection spectrum of the optical fiber spectrometer 7. When the supercapacitor is charged and discharged, the density of electric charges and ions near the electrode 9 changes correspondingly, the amplitude of the absorption envelope of the plasma resonance wave 15 changes accordingly, and the amplitude change has a corresponding relationship with the amount of electric charges stored in the supercapacitor, so the system can be used to simultaneously obtain the quantitative information of the electrochemical and optical signals, which can be used to determine the internal relationship therebetween.

In this embodiment, the light source 1 have an output spectrum of approximately 1500-1620 nm, and the range of the output spectrum of the light source 1 can optionally be configured to match with the range of the envelope of the reflection spectrum of the tilted grating in the optical fiber sensing probe 5.

In this embodiment, the tilted grating 13 of the optical fiber sensing probe 5 can be obtained by means of an excimer laser and a phase mask. It can be understood that it can also be obtained through a double beam interference. The tilted grating can have an inclination angle of approximately 5-25 degrees and a total axial length of approximately 10-20 mm.

In this embodiment, one end surface of the optical fiber in the optical fiber sensing probe 5 can be coated with a metal reflective film 18 with a thickness of more than approximately 200 nm. As such, the optical signals can be reflected by the metal reflective film 18 to realize the probe-type measurement.

Herein, the outer surface of the cladding of the optical fiber in the optical fiber sensing probe 5 can optionally be first coated with a transition layer of a chromium film having a thickness of approximately 2-3 nm by means of magnetron sputtering or evaporation, and can then be coated with a metal film having a uniform thickness at a nanometer scale. Preferably, the metal film 14 can be a gold film, which can not only effectively excite the plasma resonance waves, but also has good conductivity and stable physical and chemical properties. The metal film 14 can have a thickness of approximately 40-50 nm, which can ensure that the plasma resonance be excited with best efficiencies. After coating with the metal film 14, the optical fiber coated with the metal film 14 can be subject to an annealing treatment, preferably at approximately 300°C for more than 3 hours, so as to increase the adhesion for the metal film 14 and to release the residual stress in the coating process.

This embodiment of the disclosure further provides an optical fiber-based method for *in operando* monitoring a state of charge (SOC) of an energy storage device. With a supercapacitor as an illustrating example for the energy storage device, certain embodiments of the method include the following steps:
S1: the optical fiber sensing probe 5 is tightly aligned or packaged with one of the electrodes 9 of the supercapacitor 9, and an electrolyte is filled in the supercapacitor 6.
S2: After setting up the optical path and the supercapacitor 6, the supercapacitor 6 is operably connected to the electrochemical workstation 8, and the electrochemical workstation 8 and the optical fiber spectrometer 7 are operably connected to a computer. After setting up relevant parameters, the polarization controller 3 is adjusted to allow the light incident into the optical fiber sensing probe 5 to be in a polarized state capable of exciting surface plasma resonance (SPR) on the metal film 14.

Herein, a light emitted from the light source 1 is converted into a polarized light after passing through the polarizer 2. A polarization direction of the polarized light is adjusted by the polarization controller 3 to be substantially same as (i.e. parallel to) a writing direction of the tilted grating 13 in the optical fiber sensing probe 5. The polarized light is configured to have a polarization direction that is parallel to the writing direction of the tilted grating 13. The polarization direction of the polarized light can be determined by the amplitude of the surface plasmon resonance peaks. Specifically, when the polarization direction of the polarized light is parallel to the writing direction of the tilted grating 13, the surface plasmon resonance peaks have a maximum amplitude.

S3. The supercapacitor is arranged under a natural condition, and the whole changing process of the state of change (SOC) of the supercapacitor during the charging process and the discharging process thereof for respectively storing an electric energy into, and releasing an electric energy from, the supercapacitor, is monitored by means of an optical and electrochemical approach. This step specifically includes:
The supercapacitor 6 is charged or discharged under the excitation of electrochemical workstation 8. When the supercapacitor is being charged, ions 17 in the electrolyte form an electrical double layer on the surface of the supercapacitor electrodes 9 to thereby store the electric energy. Accompanying an oxidation reaction on the supercapacitor electrode material 16, the electric charge is further accumulated on the supercapacitor electrodes 9, and the electric energy stored in the supercapacitor reaches to the maximum after the charging process is completed. When the supercapacitor is being discharged, a reduction reaction occurs on the supercapacitor electrode material 16, and the ions 17 that accumulate on the surface of the supercapacitor electrodes 9 to form the electrical double layer diffuse back into the electrolyte in a process that is opposite to the charging process.

During the whole charging and discharging process, the optical fiber sensing probe 5 monitors the real-time change of the state of charge (SOC) of the supercapacitor. The electrochemical workstation 8 and the optical fiber spectrometer 7 further record the whole process in which the state of charge (SOC) of the supercapacitor increases during charging and reduces during discharging, and then a corresponding curve can be drawn.

The slight disturbances of the energy from the light source, of the optical path system, and/or of the environmental temperature may bring errors to the detection results of the electrochemical workstation 8 and the optical fiber spectrometer 7. The core mode of an optical fiber is only sensitive to the temperature, and is substantially insensitive to the change of environmental refractive index and/or to the change of the dielectric constant of metal film 14. Therefore, by detecting the wavelength and the amplitude of the core mode of the optical fiber, the real-time detection of the temperature information and the light source energy can be realized. Through real-time measurement of the changes of the wavelength and amplitude of the core mode of the optical fiber, the errors can thereby be corrected, which can in turn eliminate the influence of the temperature change and the external interference on the detection result, so as to realize a self-calibration functionality.

S4. Under a manual condition, different electric potentials are applied to the supercapacitor 6 to control the polarity and quantity of the electric charges stored in the supercapacitor, which in turn controls the density changes of the electric charges on the surface of the optical fiber sensing probe 5, which can be detected through the intensity change of the cladding mode of the tilted grating 13 corresponding to the wavelength of the absorption envelope of the plasma resonance wave 15 modulated by the wavelength shift of the absorption envelope of the plasma resonance wave 15. As such, the information of electric charges that are stored in and/or released by the supercapacitor can be converted into electrochemical-optical information so as to allow the monitoring for the storage or release of electric charges in the supercapacitor.

When a positive potential is applied, the density of negative ions at the supercapacitor electrodes 9 that is tightly aligned with the optical fiber sensing probe 5 increases, and the metal film 14 is in a state of electron polarization; when a negative potential is applied, the density of positive ions at the supercapacitor electrodes 9 that is encapsulated with the optical fiber sensing probe 14 increases, and the metal film 14 is in an opposite state of electron polarization. When the supercapacitor is being charged, ions in the electrolyte enter the two-dimensional or three-dimensional space of the active oxidation complexes on the surface of the supercapacitor electrodes through electrochemical reaction, and a large amount of electric charges are thereby stored in the supercapacitor electrodes. When the supercapacitor is being discharged, these ions return to the electrolyte again, and the stored electric charges are released at the same time. The optical fiber sensing probe 5 can detect the density change of the electric charges to thereby determine the state of charge (SOC) of the supercapacitor.

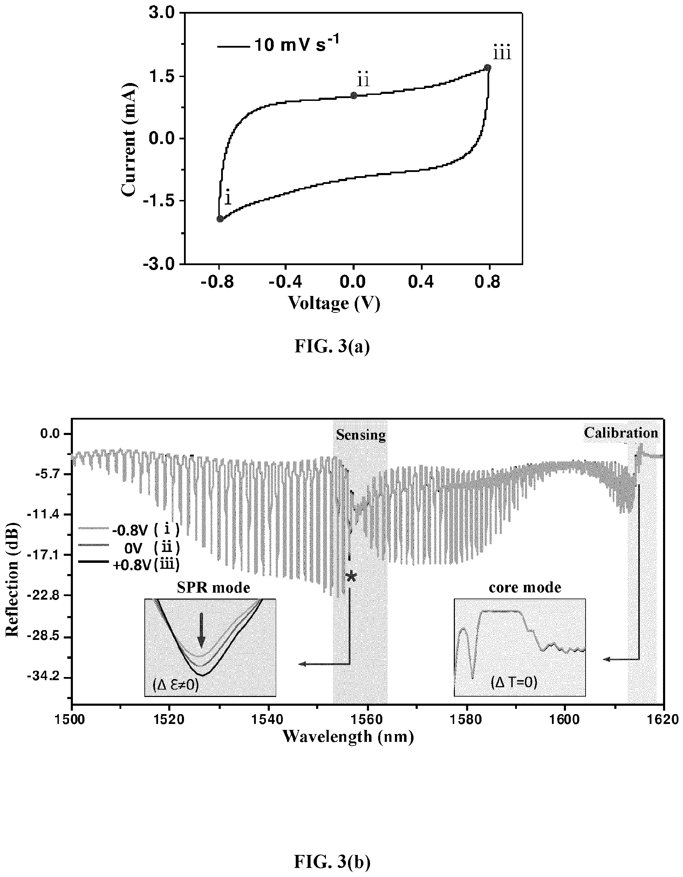

The optical fiber sensing probe 5 evanesces the light containing a plasma resonance wave 15 to an external environment outside the metal film 14, and the light interacts with the supercapacitor electrode material 16 that is modified on the surface of the supercapacitor electrode 9. At the same time, ions 17 in the electrolyte enter into the two-dimensional or three-dimensional space of the supercapacitor electrode material 16 to allow the redox reactions to occur and the density of electric charges near the supercapacitor electrode 9 to change, causing an energy loss of, and a wavelength shift of the resonance center of, the plasma resonance wave 13. This phenomenon can be detected in the optical fiber spectrometer 7, with the specific changes shown in FIGS. 3(a-b).

FIG. 3(a) shows a cyclic voltammetry (CV) response profile of the supercapacitor provided in the embodiment under a cyclic voltammetric (CV) charge and discharge test at a scanning rate of 10 mV/s excited by the electrochemical workstation. Correspondingly in FIG. 3(b), the amplitude/intensity of the surface plasma resonance (SPR), which is indicated at the asterisk "*" corresponding to the absorption envelope of SPR, alters with the change of the electric potential of the supercapacitor (i.e. supercapacitor potential). As further shown in FIG. 3(b), when the supercapacitor is under charge or discharge, the core mode of the optical fiber does not change, indicating that the detection process is carried out under the stable optical system and temperature environment conditions.

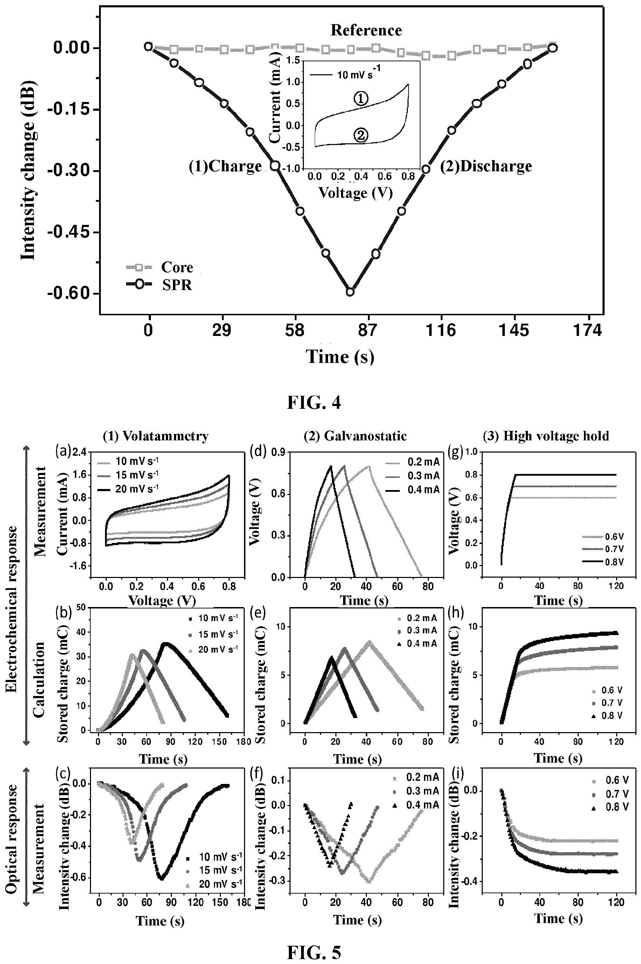

FIG. 4 relatively completely records the change of the plasma resonance intensity during the process of charging and discharging of the supercapacitor. Such a change has a substantially same trend as the change of the electric charges that are stored in, or discharged from, the supercapacitor. In this process, the intensity change corrected by the core mode is also recorded, which is indicated by the red curve in FIG. 4, indicating that the environmental temperature hardly changes in the whole monitoring process. In other words, the core mode can be used to correct the deviation of test results caused by the temperature and the unstable factors such as the light source and optical path.

As shown in FIG. 5(a), when the supercapacitor is under cyclic voltammetric (CV) charge-discharge test at a series of scanning rates, the real-time quantity change of the electric charges stored or released by the supercapacitor is obtained by calculation of a CV curve (shown in FIG. 5(b)). As shown in FIG. 5(c), the optical fiber spectrometer records a corresponding real-time curve of the SPR mode amplitude change. Similarly, FIG. 5(d) shows that the supercapacitor is under a Galvanostatic charge-discharge (GCD) at different currents, during which the real-time quantity change of the electric charges stored or released by the supercapacitor is obtained by calculation of a GCD curve (shown in FIG. 5(e)). As shown in FIG. 5(f), the optical fiber spectrometer records a corresponding real-time curve of the amplitude change of the SPR mode to be tested when the supercapacitor is under the Galvanostatic charge-discharge (GCD) test. As further shown in FIG. 5(g), the supercapacitor is under a Galvanostatic charge and voltage holding (GCVH) test at different high potentials, during which the real-time quantity change of the electric charges stored or released by the supercapacitor is obtained by calculation of a GCVH curve (shown in FIG. 5(h)). As shown in FIG. 5(i), the optical fiber spectrometer records a corresponding real-time curve of the amplitude change of the SPR mode to be tested when the supercapacitor is under the Galvanostatic charge and voltage holding (GCVH) test at the different high potentials. In each of the three charge-discharge tests of CV, GCD and GCVH, the plasma resonance intensity in the optical fiber sensing probe has a substantially same trend as the real-time quantity change of the electric charges stored in, or released by, the supercapacitor, indicating that the real-time storage and discharge of the supercapacitor, which shows that the real-time state of charge (SOC) of the supercapacitor can be monitored by means of the optical signals of the optical fiber sensing probe.

Taken together, the inventions provided in the present disclosure utilize an optical fiber sensing probe which is as fine as hair and can both transmit optical signals and acquire optical wave information to thereby realize a real-time or *in operando* monitoring of the electric potentials of a supercapacitor during the charging process and/or the discharging process thereof and to realize a real-time recording of the quantity information of electric charges. It can be implemented into a relatively narrow and small space to realize an *in situ* measurement, and can also be implemented in a simultaneous and real-time manner to measure changes of multiple parameters, such as a state of charge (SOC), an electric potential, a temperature, etc. In addition, the outer surface of the optical fiber cladding in the optical fiber sensing probe is coated with a metal film. The optical fiber sensing probe couples the energy of the surface plasmon resonance waves generated on the metal film to the external environment outside the metal film. The energy loss and the wavelength shift of the resonance center generated due to the interaction between the plasma resonance wave and the electrode material close to the surface of the metal film exhibits as an absorption envelope detected by the optical fiber spectrometer. As such, the combination of the above multidisciplinary technologies (e.g. electrochemical technology, and the surface plasmon resonance technology) can realize *in operando* and *in situ* monitoring of the charge and/or discharge of supercapacitors, thereby providing a new application prospect for monitoring the working conditions of various energy storage devices.

It is noted that the embodiments as described above represent only relatively better embodiments of the invention disclosed herein, and that the scope of protection for the disclosure is not limited to these above embodiments. Within the scope as provided in the present disclosure, any technicians familiar with the technical field who makes equivalent replacements, substitutions, or changes according to the technical schemes and the inventive ideas of the present disclosure, shall belong to the scope of protection of the present disclosure.

## Claims

1. An optical fiber system for *in operando* monitoring a state of charge (SOC) of an energy storage device, comprising a light source, a polarizer, a polarization controller, an optical fiber circulator, an optical fiber sensing probe, a supercapacitor, an optical fiber spectrometer, and an electrochemical workstation, wherein:
the light source, the polarizer, the polarization controller, the optical fiber circulator and the optical fiber sensing probe are operably connected in a sequential manner;
the optical fiber spectrometer is operably connected with the optical fiber circulator;
the supercapacitor is operably connected with the electrochemical workstation; and
the optical fiber sensing probe is arranged in the supercapacitor.

2. The optical fiber system of claim 1, wherein the optical fiber sensing probe comprises an optical fiber, wherein:
the optical fiber is engraved with a tilted grating, and an outer surface of a cladding of the optical fiber is coated with a metal film having an uniform thickness at a nanometer scale;
a light emitted by the light source sequentially passes through the polarizer, the polarization controller and the optical fiber circulator, and sheds into the optical fiber sensing probe;
a cladding mode generated in the optical fiber of the optical fiber sensing probe is coupled to the metal film to thereby stimulate a surface plasmon resonance (SPR) of the metal film, wherein waves of the surface plasma resonance exhibit as an absorption envelope in a reflection spectrum of the optical fiber spectrometer, wherein:
a dielectric constant of the metal film changes under charging and/or discharging of the supercapacitor; and
an amplitude of the absorption envelope alters accordingly.

3. The optical fiber system of claim 2, wherein:
the tilted grating in the optical fiber of the optical fiber sensing probe is obtained by means of an excimer laser and a phase mask, or by a double beam interference; and
the tilted grating has an inclination angle of approximately 5-25 degrees and a total axial length of approximately 10-20 mm.

4. The optical fiber system of claim 2, wherein in the optical fiber sensing probe, an end surface of the optical fiber is coated with a metal reflective film with a thickness of more than 200 nm.

5. The optical fiber system of claim 2, wherein in the optical fiber sensing probe:
the outer surface of the cladding of the optical fiber is first coated with a transition layer of a chromium film having a thickness of 2-3 nm by means of magnetron sputtering or thermal evaporation deposition, and is then coated with a metal film having a uniform thickness at a nanometer scale; and
the optical fiber coated with the metal film undergoes an annealing treatment.

6. The optical fiber system of claim 1, wherein in the optical fiber sensing probe, the supercapacitor is filled with an electrolyte, and is provided with two electrodes of the supercapacitor, wherein:
part of each of the two electrodes is disposed in the electrolyte; and
the optical fiber sensing probe is aligned tightly with one of the two electrodes.

7. The optical fiber system of claim 6, wherein in the optical fiber sensing probe, the electrochemical workstation comprises a counting electrode, a reference electrode and a working electrode, wherein:
the counting electrode and the reference electrode are electrically connected to one of the two electrodes of the supercapacitor; and
the working electrode is electrically connected to another of the two electrodes of the supercapacitor.

8. An optical fiber-based method for monitoring a state of charge (SOC) of an energy storage device, comprising:
S1: tightly aligning an optical fiber sensing probe with one electrode of the supercapacitor, wherein an electrolyte is filled in the supercapacitor, and a light emitted from a light source is converted into a polarized light after passing through a polarizer, and a polarization direction of the polarized light is adjusted by the polarization controller to be substantially same as a writing direction of tilted gratings in the optical fiber sensing probe;
S2: after setting up an optical path and the supercapacitor, operably connecting the supercapacitor with an electrochemical workstation, and communicatively connecting the electrochemical workstation and an optical fiber spectrometer to a computer; setting up relevant parameters of the polarization controller such that the light incident into the optical fiber sensing probe is in a polarized state capable of exciting surface plasma resonance (SPR) on a metal film coating an outer surface of a cladding of the optical fiber in the optical fiber sensing probe;
S3: arranging the supercapacitor under a natural condition, and monitoring, by means of an optical and electrochemical approach, a whole changing process of a state of change (SOC) of the supercapacitor during charging and discharging thereof for respectively storing an electric energy into, and releasing an electric energy from, the supercapacitor;
S4: applying different electric potentials to the supercapacitor to control a polarity and quantity of electric charges stored in the supercapacitor, and to in turn control a change of densities of the electric charges on the surface of the optical fiber sensing probe, so as to detect the storage or release of the electric charges in the supercapacitor.

9. The optical fiber-based method of claim 8, wherein the monitoring, by means of an optical and electrochemical approach, a whole changing process of a state of change (SOC) of the supercapacitor during charging and discharging thereof for respectively storing an electric energy into, and releasing an electric energy from, the supercapacitor in step S3 comprises:
arranging that the supercapacitor is charged or discharged under excitation of the electrochemical workstation, wherein:
when the supercapacitor is being charged, ions in the electrolyte form an electrical double layer on surface of the supercapacitor electrodes to thereby store the electric energy; and accompanying an oxidation reaction on the supercapacitor electrode material, the electric charge is further accumulated on the supercapacitor electrodes, and the electric energy stored in the supercapacitor reaches a maximum after the charging process is completed; and
when the supercapacitor is being discharged, a reduction reaction occurs on the supercapacitor electrode material, and the ions that accumulate on the surface of the supercapacitor electrodes to form the electrical double layer diffuse back into the electrolyte in a process that is opposite to the charging process;
during the whole charging and discharging process, the optical fiber sensing probe monitors a real-time change of the state of charge (SOC) of the supercapacitor, wherein the electrochemical workstation and the optical fiber spectrometer further record a whole process in which the state of charge (SOC) of the supercapacitor increases during charging and reduces during discharging so as to draw a corresponding curve.

10. The optical fiber-based method of claim 8, wherein step S3 comprises:
when a positive potential is applied, the density of negative ions at the end of the supercapacitor electrode that is tightly aligned with the optical fiber sensing probe increases, and the metal film is in a state of electron polarization; and
when a negative potential is applied, the density of positive ions at the end of the supercapacitor electrode that is tightly aligned with the optical fiber sensing probe increases, and the metal film is in an opposite state of electron polarization.
